(19) Europäisches Patentamt
European Patent Office
Office européen des brevets

(11) **EP 2 056 098 B1**

(12) **EUROPEAN PATENT SPECIFICATION**

(45) Date of publication and mention of the grant of the patent:
**17.12.2014 Bulletin 2014/51**

(51) Int Cl.:
**G01N 27/04** *(2006.01)* **G01N 27/20** *(2006.01)*
**H01L 21/66** *(2006.01)*

(21) Application number: **08165610.0**

(22) Date of filing: **01.10.2008**

(54) **A method for detection and analysis of impurity content in refined metallurgical silicon**

Verfahren zur Detektion und Analyse des Verunreinigungsgehalts in raffiniertem metallurgischem Silizium

Procédé pour la détection et l'analyse de la teneur en impuretés dans un silicium métallurgique raffiné

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **08.10.2007 CN 200710132843**

(43) Date of publication of application:
**06.05.2009 Bulletin 2009/19**

(73) Proprietor: **CSI Cells Co. Ltd.**
**Suzhou New District**
**Suzhou Jiangsu 215-123 (CN)**

(72) Inventors:
• **Chen, Genmao**
**Suzhou Jiangsu 215-123 (CN)**
• **Peng, Jiang**
**Suzhou Jiangsu 215-123 (CN)**

(74) Representative: **Lermer, Christoph et al**
**LermerRaible GbR Patent- und Rechtsanwälte**
**Lessingstrasse 6**
**80336 München (DE)**

(56) References cited:
**US-A- 3 432 753      US-A1- 2008 177 422**

• **R. S. HOCKETT: "Solar Grade Feedstock Evaluation Using GDMS and SIMS", CRYSTAL CLEAR WORKSHOP, PA.120, 13 November 2008 (2008-11-13), 14 November 2008 (2008-11-14), pages 1-23, XP002665678, Retrieved from the Internet: URL:www.eaglabs.com /files/ papers/PA120.pdf**
• **XINMING HUANG ET AL: "Ga segregation in Czochralski-Si crystal growth with B codoping", JOURNAL OF CRYSTAL GROWTH, ELSEVIER, AMSTERDAM, NL, vol. 310, no. 14, 1 July 2008 (2008-07-01) , pages 3335-3341, XP002507626, ISSN: 0022-0248, DOI: 10.1016/J.CRYSGRO. 2008.04.013 [retrieved on 2008-04-15]**

**Description**

Technical Field

This invention relates to a method for detection and analysis of impurity content in silicon material, and more particularly to a method for detection and analysis of impurity content in refined metallurgical silicon.

Background of the invention

As people are getting more and more aware of the problems of energy sources and environment pollution, the utilization of solar energy has changed from research stage into industrialization. The solar photovoltaic technology has drawn universal attention, and silicon solar cells have begun to be widely used.

Conventional silicon cell wafers are made on the P-type semiconductor substrates of silicon. The P-type wafer is made by doping of boron (0.02 ~ 0.25 ppmw) into ultra-pure silicon materials (better than 8N), so after the crystal growth, the resistivity is controlled within the range of 0.5 ~ 5 $\Omega$ .cm. The wafer produced this way has very high purity and the contents of other impurities can be neglected. However, the price of silicon cells using ultra-pure silicon wafer is very expensive, which is the major problem that affects the wider application of solar cells.

Refined metallurgical silicon is a new type of low-cost silicon solar cell material. Its purity content is 2 ~ 3 N lower than conventional solar cell grade silicon material, that is only 5 ~ 6 N. The impurities of boron in refined metallurgical silicon is as high as 1 ~ 2 ppmw, and the content of phosphorus is also quite high, which is generally in the range of 3~ 12 ppmw. Boron is a P-type impurity, while phosphorus is an N-type impurity, so the refined metallurgical silicon is a kind of impurity compensation material. In the purification process of refined metallurgical silicon material, a commonly used method is directional crystallization. As the segregation coefficient of boron is 0.8, boron as an impurity will be distributed evenly in the material, but the segregation coefficient of phosphorus in silicon is relatively smaller which is about 0.33, making the phosphorus as an impurity in refined metallurgical silicon is distributed unevenly, and the content of phosphorus shows an exponential growth from one end of the crystal to the other end.

Conventional method for detection and analysis of impurity contents includes glow discharge mass spectrometry (GDMS) and plasma mass spectrometry (ICP-MS). When used in the detection of impurities in said refined metallurgical silicon, these two methods both have the following defects: (1) because each time you can only detect samples of about 1 g, however the distribution of impurities vary a lot, and therefore, it is impossible to get an accurate average content level of impurities in a large amount of the refined metallurgical silicon (such as a crystal ingot casting of 240 kg in a furnace). (2) Both these two conventional method require expensive equipment, and the course of preparing sample is very complicated, and besides, the cost of using multi-point sampling detection method is too high and multi-point sampling detection method could not be applied to actual production.

For those reasons, it is impossible to accurately control the doping and the resistivity in the course of using refined metallurgical silicon to cast crystal ingots for solar cells, which results in very low yield.

Thus, if we can provide a detection and analysis method to accurately detect the impurity content in a large amount of refined metallurgical silicon material, then it is conducive to determine the doping in the course of making solar cells, so as to control the resistivity and improve the yield.

Contents of the invention

The object of the present invention is to provide a method for detection and analysis of impurity contents in refined metallurgical silicon, so as to simply and accurately analyze the average impurity of phosphorus and boron in large amounts of refined metallurgical silicon.

This object is achieved according to the technical solution described below: a method for detection and analysis of impurity content of refined metallurgical silicon, comprising:

(1) select the measuring points on the crystal rods or crystal ingots along the crystallization direction, with the distance between two adjacent measuring points selected no more than 2 cm on crystal rod, and no more than 1 cm on ingot; calling the ratio between the weight from the starting point to each measuring point of crystal rod or crystal ingot and the material weight of crystal rod or ingot "crystallized fraction", measuring the resistivity at each measuring point and acquire the measured value of resistivity according to the distribution of crystallized fraction;

(2) according to the estimated value of impurity content as well as the segregate coefficient in the original silicon material, get the estimated value of the content of boron and phosphorus at each measuring point and calculate the estimated net redundant carrier concentration; then calculate measured value of net redundant carrier concentration according to the measured value of resistivity at every measuring point;

(3) compare the estimated value of net redundant carrier concentration with that of the measured value, and adjust the estimated value of impurity content in the silicon material according to exponential segregation of each point as well as the crystallized fraction to get the new estimated net redundant carrier concentration, and repeat the above steps and use regression analysis to determine the impurity content distribution of boron and phosphorus, so that the average square of the difference of the estimated value and measured value of the net redundant carrier concentration is less than 0.01;

(4) get the average impurity content of boron and phosphorus in the silicon material according to the distribution status of impurity based on all the measuring points.

In above technical solution, said crystal rods are made by pulling process from mono-crystalline furnace, while said crystal ingots are made by casting process from casting furnace.

The general idea of the above solution is: using the distribution rule of the impurity and the resistivity along the crystallization direction by different segregation coefficients of phosphorus and boron in the course of crystallization of silicon, and through measuring the distribution of resistivity, calculate the average impurity contents of phosphorus and boron through computer simulation of comparing and analyzing the estimated value and measured.

In the oriented crystallization of refined metallurgical silicon, the content of boron and phosphorus as well as the resistivity will be in an exponential distribution along the crystallization direction, and the measured value of each measuring point is given by the following formulas:

$$C_B(F) = S_B \cdot C_{B0}(1-F)^{\wedge}(S_B - 1) \qquad (1)$$

$$C_P(F) = S_P \cdot C_{P0}(1-F)^{\wedge}(S_P - 1) \qquad (2)$$

$$N_{CC} = (C_B - C_P) \times 5 \times 10^{17}/cm^3 \qquad (3)$$

$$\rho = \frac{1}{N_{CC}\,q\mu} \qquad (4)$$

Where, F stands for the crystallized fraction, that is, the ratio between the weight from the starting point to each measuring point of crystal rod or crystal ingot and the material weight of whole crystal rod or ingot. The value is between 0 to 1; $C_B$ (F) and $C_P$ (F) respectively stands for the estimated value of content of boron and phosphorus at the measuring point where the crystallized fraction is F; $C_{B0}$ and $C_{P0}$ respectively stands for the estimated average value of impurity contents of boron and phosphorus in the material to be inspected; $S_B$ and the $S_P$ respectively stands for the segregation coefficient of boron and phosphorus in silicon, which is 0.8 and 0.33 respectively; $N_{CC}$ is the net redundant carrier density; p is the resistivity along the direction of crystal; q is the quantity of electric charge of the carrier; and $\mu$ is the carrier's mobility.

First, measure the resistivity p and crystallized fraction F at the measuring points distributed along the orientation of crystallization on crystal rod to get the measured value of resistivity related to the distribution data of crystal ratio F; use formula (4) to calculate the distribution data of $N_{cc}$ related to F; Secondly, use formula (1) and (2) to get the estimated value of $C_B(F)$ and $C_P(F)$ at the measuring points according to the initial impurity content, and then use formula (3) to get the distribution data $N'_{CC}$ which is related to F according to estimated value $N_{CC}$.

Finally, compare $N_{CC}$ and $N'_{CC}$, take the number $\Delta X$ of the square of the difference between the two as the object to study, which is:

$$\Delta x = (Ncc - N'cc)^2 \qquad (5)$$

Because there are a number of measuring points, using the formulas we can get a group of data, and by using computer to repeatedly adjust the value of $C_{B0}$ and $C_{P0}$ until the distribution of $\Delta x$ in the entire simulated curve is small enough, and at this time the $C_{B0}$ and $C_{P0}$ are the average contents of boron and phosphorus in the refine metallurgical silicon.

The quantity and distribution of measuring points have impact on the accuracy of simulation curve, which is acknowledged by technicians in this field, therefore, they can determine the quantity of measuring points as well as the distribution density of each section according to the density of net redundant carrier and its distribution curve.

With using of the above technical solution, this invention has following effects compared with the background technologies:

(1) This invention has creatively adopted the method of inspecting the impurity content of phosphorus and boron by measuring the resistivity and simulating it to form a distribution curve. It is most suitable for conditions that the distribution of impurity is uneven in the materials with oriented crystallization. It can detect accurately the average impurity contents of phosphorus and boron in a large amount of refined metallurgical silicon. Thus we can well control the doping of the casting, the resistivity of crystal ingot and the effective utilization of material of crystal ingot so as to improve the performance of solar cells and effective use of materials as well as reduce cost.

(2)This invention can detect the impurity contents by only measuring the resistivity of certain points, which is simple, low-cost and suitable for industrial applications.

Description of example embodiments

This invention will be best understood with reference to the following description of example embodiments:

Example 1:

In a 60 $C_Z$ crystal furnace with 35kg of refined metallurgical silicon, we use straight pulling process for mono-crystallized silicon to produce refined metallurgical silicon rod and use conduct the simulation analysis of impurity content of phosphorus and boron.

Select 56 measuring points along the direction of crystallization, and the crystallized fraction of each point is shown in Table 1. Measure the resistivity p at each point, and use below formula (4) to calculate the $N_{cc}$ at each point and get a group of distribution data. Then we will use formula (1), (2) and crystallized fraction F to get the function of $C_B$ and $C_P$ with relate to F, which is $C_B(F)$ and $C_P(F)$, and then use formula (3) to get the estimated distribution data.

The formulas are shown below:

$$\mathbf{C_B(F)=S_B \cdot C_{B0}(1-F)^{\wedge}(S_B-1)} \qquad (1)$$

$$\mathbf{C_P(F)=S_P \cdot C_{P0}(1-F)^{\wedge}(S_P-1)} \qquad (2)$$

$$\mathbf{N_{CC}=(C_B-C_P)\times 5 \times 10^{17}/cm^3} \qquad (3)$$

$$\rho = \frac{1}{N_{cc}\,q\,\mu} \qquad (4)$$

where F stands for the crystallized fraction, that is, the ratio between the weight from the starting point to each measuring point of crystal rod or crystal ingot and the material weight of whole crystal rod or ingot. The value is between 0 to 1; $C_B(F)$ and $C_P(F)$ respectively stands for the estimated value of content of boron and phosphorus at the measuring point where the crystallized fraction is F; $C_{B0}$ and $C_{P0}$ respectively stands for the estimated average value of impurity contents of boron and phosphorus in the material to be inspected; $S_B$ and the $S_P$ respectively stands for the segregation coefficient of boron and phosphorus in silicon, which is 0.8 and 0.33 respectively; $N_{CC}$ is the net redundant carrier density; p is the resistivity along the direction of crystal; q is the quantity of electric charge of the carrier; and $\mu$ is the carrier's mobility.

In this example, all groups of data as shown in Table 1 below, through regression analysis to simulate, we can get the value of $C_{B0}$ and $C_{P0}$ are 2.39ppma and 3.1224ppma respectively, which are the average impurity contents in refined metallurgical silicon.

**Table 1**

| F | $\rho$ | $N_{CC}$(E17) | $C_P$ | $C_B$ | $N'_{cc}$(E17) | $\Delta^x$ |
|---|---|---|---|---|---|---|
| 0.033 | 0.43 | 0.38 | 1.12 | 1.92 | 0.40 | 0.00057592 |
| 0.058 | 0.43 | 0.38 | 1.14 | 1.94 | 0.40 | 0.000378845 |
| 0.12 | 0.43 | 0.38 | 1.19 | 1.96 | 0.39 | 4.93513E-05 |
| 0.145 | 0.425 | 0.385 | 1.21 | 1.97 | 0.38 | 1.24836E-05 |
| 0.17 | 0.46 | 0.35 | 1.23 | 1.98 | 0.38 | 0.000653105 |
| 0.195 | 0.46 | 0.35 | 1.26 | 2.00 | 0.37 | 0.000370973 |
| 0.22 | 0.46 | 0.35 | 1.28 | 2.01 | 0.36 | 0.000157386 |
| 0.245 | 0.48 | 0.34 | 1.31 | 2.02 | 0.36 | 0.00023623 |
| 0.27 | 0.49 | 0.33 | 1.34 | 2.04 | 0.35 | 0.000312882 |
| 0.3013 | 0.55 | 0.28 | 1.38 | 2.05 | 0.34 | 0.003280881 |
| 0.3638 | 0.62 | 0.235 | 1.47 | 2.09 | 0.31 | 0.006144486 |
| 0.3893 | 0.66 | 0.225 | 1.51 | 2.11 | 0.30 | 0.005964243 |
| 0.4394 | 0.72 | 0.205 | 1.59 | 2.15 | 0.28 | 0.00523738 |
| 0.4644 | 0.88 | 0.165 | 1.64 | 2.17 | 0.26 | 0.009653307 |
| 0.4957 | 0.9 | 0.16 | 1.71 | 2.19 | 0.24 | 0.006996686 |
| 0.5075 | 1 | 0.145 | 1.73 | 2.20 | 0.24 | 0.008213073 |
| 0.52 | 1.1 | 0.13 | 1.76 | 2.21 | 0.23 | 0.009353465 |
| 0.5325 | 1.2 | 0.12 | 1.79 | 2.23 | 0.22 | 0.009475104 |
| 0.57 | 1.3 | 0.1 | 1.89 | 2.26 | 0.19 | 0.007410072 |
| 0.5825 | 1.5 | 0.093 | 1.93 | 2.28 | 0.17 | 0.00663728 |
| 0.595 | 1.6 | 0.087 | 1.97 | 2.29 | 0.16 | 0.00565125 |
| 0.6075 | 1.9 | 0.075 | 2.01 | 2.31 | 0.15 | 0.005496258 |
| 0.611 | 2.5 | 0.055 | 2.02 | 2.31 | 0.15 | 0.008161999 |
| 0.6235 | 3 | 0.045 | 2.06 | 2.32 | 0.13 | 0.007439628 |
| 0.6423 | 7 | 0.019 | 2.13 | 2.35 | 0.11 | 0.007977192 |
| 0.7225 | -3.8 | -0.012 | 2.51 | 2.47 | -0.02 | 9.54327E-05 |
| 0.735 | -2.1 | -0.022 | 2.59 | 2.49 | -0.05 | 0.000705561 |
| 0.7475 | -1.5 | -0.032 | 2.67 | 2.52 | -0.08 | 0.002096356 |
| 0.76 | -1 | -0.049 | 2.76 | 2.54 | -0.11 | 0.003695244 |
| 0.7725 | -0.7 | -0.071 | 2.86 | 2.57 | -0.14 | 0.00547454 |
| 0.82 | -0.35 | -0.158 | 3.33 | 2.69 | -0.32 | 0.025777198 |
| 0.8575 | -0.2 | -0.3 | 3.88 | 2.82 | -0.53 | 0.051650242 |
| 0.9075 | -0.1 | -0.8 | 5.14 | 3.08 | -1.03 | 0.052266102 |

**Claims**

1. A method for detection and analysis of impurity content of refined metallurgical silicon, comprising:

(1) select the measuring points on the crystal rods or crystal ingots along the crystallization direction, with the distance between two adjacent measuring points selected no more than 2 cm on crystal rod, and no more than 1 cm on ingot; calling the ratio between the weight from the starting point to each measuring point of crystal rod or crystal ingot and the material weight of crystal rod or ingot "crystallized fraction", measuring the resistivity at each measuring point and acquire the measured value of resistivity $\rho$ according to the distribution of crystallized fraction F;

(2) according to the estimated value of impurity content as well as the segregation coefficient of boron $S_B$ and phosphorus $S_P$ in the original silicon material, get the estimated value of the content of boron $C_B$ (F) and phosphorus $C_P$ (F) at each measuring point and calculate the estimated net redundant carrier concentration $N_{CC}$ using the formula:

$$\rho = 1/(N_{CC} \cdot q\mu)$$

wherein q is the quantity of electric charge of the carrier, and $\mu$ is the estimated net redundant carrier's mobility; then calculate measured value of net redundant carrier concentration $N_{CC'}$ according to the measured value of resistivity at every measuring point, using the formulas:

$$C_B(F)=S_B \cdot C_{B0}(1-F)^{\wedge}(S_B-1)$$

$$C_P(F)=S_P \cdot C_{P0}(1-F)^{\wedge}(S_P-1)$$

$$N_{CC}'=(C_B-C_P)\times 5 \times 10^{17}$$

wherein $C_{B0}$ and $C_{P0}$ respectively stands for the estimated average value of impurity contents of boron and phosphorus in the material;

(3) compare the estimated value of net redundant carrier concentration $N_{CC}$ with that of the measured value $N_{CC'}$, using formula

$$\Delta x=(Ncc-N'cc)^2$$

and adjust the estimated value of impurity content in the silicon material according to exponential segregation of each point as well as the crystallized fraction to get the new estimated net redundant carrier concentration, and repeat the above steps and use regression analysis to determine the impurity content distribution of boron and phosphorus, so that the average square of the difference of the estimated value and measured value of the net redundant carrier concentration is less than 0.01;

(4) get the average impurity content of boron and phosphorus in the silicon material according to the distribution status of impurity based on all the measuring points.

## Patentansprüche

1. Verfahren zur Detektion und Analyse des Verunreinigungsgehalts von verfeinertem metallurgischem Silizium, umfassend:

(1) Auswahl der Messpunkte des kristallinen Stabs oder kristallinen Rohblocks entlang der Kristallisationsrichtung, wobei ein Abstand zwischen zwei benachbarten Messpunkten am kristallinen Stab von nicht mehr als 2 cm gewählt wird, und von nicht mehr als 1 cm am kristallinen Rohblock; Benennen des Verhältnisses zwischen dem Gewicht vom Anfangspunkt zu jedem Messpunkt des kristallinen Stabs oder des kristallinen Rohblocks und dem Materialgewicht des kristallinen Stabs oder des kristallinen Rohblocks als "kristallisierter Bruchteil", Messen des spezifischen Widerstands $\rho$ entsprechend der Verteilung des kristallisierten Bruchteils F;

(2) Entsprechend dem geschätzten Wert des Verunreinigungsgehalts sowie des Segregationskoeffizienten von Bor $S_B$ und Phosphor $S_P$ im ursprünglichen Silizium-Material, Erhalten des geschätzten Wertes des Gehalts von Bor $C_B(F)$ und Phosphor $C_P$ (F) an jedem Messpunkt und Berechnen der geschätzten reinen überschüssigen Landungsträgerkonzentration $N_{CC}$ unter Benutzung der Formel:

$$R = 1 / ( N_{CC} * q * \mu)$$

Wobei q die Größe der Ladung des Ladungsträgers, und $\mu$ die geschätzte Beweglichkeit des reinen überschüssigen Ladungsträgers ist;

danach Berechnung des gemessenen Werts der reinen überschüssigen Landungsträgerkonzentration $N_{CC}'$ entsprechend dem gemessenen Wert des spezifischen Widerstands an jedem Messpunkt, unter Verwendung der Formeln:

$$C_B(F) = S_B * C_{B0} (1 - F) {\char`\^} (S_B - 1)$$

$$C_P(F) = S_P * C_{P0} (1 - F) {\char`\^} (S_P - 1)$$

$$N_{CC}' = (C_B - C_P ) * 5 * 10^{17}$$

Wobei $C_{B0}$ bzw. $C_{P0}$ für die geschätzten durchschnittlichen Verunreinigungsgehalte von Bor und Phosphor im Material stehen;

(3) Vergleich des geschätzten Werts der reinen überschüssigen Landungsträgerkonzentration $N_{CC}$ mit dem des gemessenen Werts Ncc' unter Benutzung der Formel:

$$\Delta x = (N_{cc} - N_{cc}')$$

und Anpassen des geschätzten Werts des Verunreinigungsgehalts im Silizium-Material entsprechend der exponentiellen Segregation jedes Punkts sowie dem kristallisierten Bruchteil, um die neue geschätzte reine überschüssige Ladungsträgerkonzentration zu erhalten, und Wiederholen der obigen Schritte und Verwenden einer Regressionsanalyse, um die Verunreinigungsgradverteilung von Bor und Phosphor zu bestimmen, sodass das durchschnittliche Quadrat des Unterschieds des geschätzten Werts und des gemessenen Werts der reinen überschüssigen Landungsträgerkonzentration kleiner als 0,01 ist;

(4) Erhalten des durchschnittlichen Verunreinigungsgehalts von Bor und Phosphor im Silizium-Material entsprechend dem Verteilungszustand der Verunreinigung basierend auf allen Messpunkten.

## Revendications

1. Procédé pour la détection et l'analyse de la teneur en impuretés de silicium métallurgique raffiné comprenant :

(1) la sélection des points de mesure sur les tiges de cristal ou les lingots de cristal le long de la direction de cristallisation, avec la distance entre deux points de mesure adjacents sélectionnés qui n'est pas supérieure à 2 cm sur la tige de cristal et pas supérieure à 1 cm sur le lingot de cristal, appel du le rapport entre le poids du point de départ à chaque point de mesure de la tige de cristal ou du lingot de cristal et le poids matériel de "fraction cristallisée" de la tige de cristal ou du lingot de cristal, la mesure de la résistivité à chaque point de mesure et acquisition de la valeur mesure de résistance $\rho$ selon la distribution de la fraction cristallisée F ;

(2) selon la valeur estimée de la teneur en impuretés aussi bien que le coefficient de ségrégation du bore $S_B$ et du phosphore $S_P$ dans le matériau silicium d'origine, obtention de la valeur estimée de la teneur en bore $C_B$ (F) et en phosphore $C_P$ (F) à chaque point de mesure et calcul de la concentration de porteur redondante nette estimée $N_{CC}$ en utilisant la formule :

$$\rho = 1/(N_{CC} \cdot q \mu)$$

dans laquelle $\rho$ est la quantité de charge électrique du porteur et $\mu$ est la mobilité de porteur redondante nette estimée,

ensuite calcul de la valeur mesurée de concentration de porteur redondante nette $N_{CC'}$ selon la valeur mesurée de résistance à chaque point de mesure en utilisant les formules :

$$C_B(F) = S_B \cdot C_{B0}(1-F)^{\wedge}(S_B - 1)$$

$$C_P(F) = S_P \cdot C_{P0}(1-F)^{\wedge}(S_P - 1)$$

$$N_{CC}' = (C_B - C_P) \times 5 \times 10^{17}$$

dans lesquelles $C_{B0}$ et $C_{P0}$ sont respectivement la valeur moyenne estimée des teneurs d'impuretés de bore et de phosphore dans le matériau ;

(3) comparaison de la valeur estimée de concentration de porteur redondante nette $N_{CC}$ avec celle de la valeur mesurée $N_{CC'}$ en utilisant la formule

$$\Delta x = (N_{cc} - N'_{cc})^2$$

et ajustage de la valeur estimée de la teneur en impuretés dans le matériau silicium selon la ségrégation exponentielle de chaque point ainsi que de la fraction cristallisée pour obtenir la nouvelle concentration de porteur redondante nette estimée et répétition des étapes ci-dessus et utilisation de l'analyse de régression pour déterminer la distribution de la teneur en impuretés du bore et du phosphore si bien que le carré moyen de la différence de la valeur estimée et de la valeur mesurée de la concentration de porteur redondante nette est inférieure à 0,01 ;

(4) obtention de la teneur moyenne en impuretés du bore et du phosphore dans le matériau silicium selon le statut de distribution d'impuretés sur la base de tous les points de mesure.